Europäisches Patentamt

European Patent Office

Office européen des brevets

(19)

(11) Veröffentlichungsnummer: **0 264 628**

**A1**

(12) **EUROPÄISCHE PATENTANMELDUNG**

(21) Anmeldenummer: 87113604.0

(22) Anmeldetag: 17.09.87

(51) Int. Cl.⁴: **C14C 3/18** , C14C 3/20

(30) Priorität: 25.09.86 DE 3632587

(43) Veröffentlichungstag der Anmeldung:
27.04.88 Patentblatt 88/17

(84) Benannte Vertragsstaaten:
AT BE CH DE ES FR GB IT LI NL

(71) Anmelder: **CASSELLA Aktiengesellschaft**
**Hanauer Landstrasse 526**
**D-6000 Frankfurt am Main 61(DE)**

(72) Erfinder: **Förster, Frank, Dr.**
**Auf der Rosenhöhe 5**
**D-6050 Offenbach(DE)**
Erfinder: **Keller, Karlfried, Dr.**
**Marktstrasse 127**
**D-6000 Frankfurt/M. 60(DE)**
Erfinder: **Becker, Hermann**
**Mühlstrasse 9**
**D-6054 Rodgau 1-Jügesheim(DE)**
Erfinder: **Lotz, Werner, Dr.**
**Rosertblick 16**
**D-6272 Niedernhausen(DE)**

(74) Vertreter: **Urbach, Hans-Georg, Dr. et al**
**Hanauer Landstrasse 526**
**D-6000 Frankfurt am Main 61(DE)**

(54) Verfahren zur Gerbung von Leder.

(57) Bei dem Verfahren zur Gerbung von Leder, bei dem Häute mit einem wasserlöslichen Melamin-Formaldehyd-Harz zum Schluß unter Zusatz eines sauren Katalysators gegerbt werden, wird ein Melamin-Formaldehyd-Harz verwendet, das zumindest teilweise mit einem Glykolether und/oder Alkylglykolether verethert ist.

EP 0 264 628 A1

## Verfahren zur Gerbung von Leder

Die Chromgerbung, die im Verlauf der vergangenen 60 bis 80 Jahre eine beherrschende Position in der Lederherstellung erreicht hat, ist im letzten Jahrzehnt aufgrund der hohen Abwasserbelastung mit Chrom-Salzen zunehmend unter ökologischen Druck geraten.

Da eine Rückkehr zu den vor der Chromgerbung über Jahrtausende betriebenen Gerbmethoden mit vegetabilen oder tierischen Gerbstoffen mit einschneidenden Eigenschaftsverlusten, z.B. bei der Lichtechtheit oder der Temperaturbeständigkeit der Leder, bezahlt werden müßte, hat es nicht an Versuchen gefehlt, die Chrom-Salze in der Gerbung durch andere rein mineralische Gerbstoffe, wie Titan-, Zirkonium-oder Aluminiumsalze, oder durch Kombination derselben mit vegetabilen Gerbstoffen zu ersetzen.

Allen diesen Verfahren ist jedoch gemeinsam, daß sie lediglich das Chrom-Salz durch ein anderes Mineralsalz im Abwasser ersetzen und zusätzlich in einigen Fällen noch zu einer verstärkten Belastung des Abwassers mit Alkalisalzen führen.

Des weiteren hat es in der Vergangenheit nicht an Versuchen gefehlt, die Mineralgerbung durch Melamin-Formaldehyd-Harzgerbungen zu ersetzen. Hierbei wurden die in Wasser gelösten Harze in möglichst kurzer Flotte in die gebeizte oder auch - schwach gepickelte Blöße eingewalkt und anschließend die Kondensation der Harze durch Zusatz eines sauren Katalysators, vorzugsweise Ameisensäure, ausgelöst.

Aus der Literatur (Miekeley "Das Leder" 4 - (1953), S.298 ff.; Kutsidi, Strakhov, Kozh.Obuvn.Prom 5, 16 (1963); CA 60, 10940f (1964)) ist bekannt, daß unveretherte Melamin-Formaldehyd-Harze zwar auf gepickelten Häuten ohne Chromzusatz ausreichende Gerbeffekte bewirken können, daß die so gegerbten Leder aber sehr wasserzügig sind und vor allem beim Lagern stark verspröden.

Auch methyl-bzw. butylveretherte Melamin-Formaldehyd-Harze werden als Gerbstoffe vorgeschlagen (Miekeley (s.o.); Hachihama, Kyogoku, Technol.-Repts. Osaka Univ. 6, 397 (1956); CA 52, 10622a (1958)). Die mit butylveretherten Melamin-Formaldehyd-Harzen gegerbten Leder waren jedoch zu dünn, die mit methylveretherten Melamin-Formaldehyd-Harzen gegerbten Leder waren rein weiß, besaßen eine hervorragende Lichtechtheit und Fülle sowie hohe Alkalibeständigkeit und zeigten aufgrund ihres kationischen Charakters ein gutes Aufnahmevermögen für saure und substantive Farbstoffe. Neben diesen positiven Eigenschaften wiesen diese Leder jedoch einen sehr - schwerwiegenden Mangel hinsichtlich ihres Reißfestigkeitsverhaltens in Abhängigkeit von der Zeit auf. Unmittelbar nach der Gerbung besaßen diese mit Melamin-Formaldehyd-Harzen gegerbten Leder eine sehr gute Reißfestigkeit. Schon nach kurzer Lagerung nahm die Reißfestigkeit jedoch stark ab und fiel innerhalb von etwa vier Wochen auf 50 % oder weniger des ursprünglichen Wertes ab.

Eine Alleingerbung der Haut mit Melamin-Formaldehyd-Harzen war daher trotz der erzielten hervorragenden sonstigen Ledereigenschaften nicht möglich und die Anwendbarkeit dieser Harzklasse auf die Nachgerbung von Chromleder beschränkt.

Demgegenüber wurde nunmehr gefunden, daß man in einem umweltfreundlichen Gerbverfahren chrom-bzw. mineralfreie Vollgerbungen mit guter Fülle und Flammfestigkeit ohne Versprödungsneigung auf entkälkten und gebeizten Häuten erzielen kann, wenn man als Gerbmittel wasserlösliche Melamin-Formaldehyd-Harze verwendet, die zumindest teilweise mit einem Glykolether und/oder Alkylglykolether verethert sind.

Außerdem wurde gefunden, daß die Beständigkeit des Harzes gegen die von der Haut mitgebrachten Elektrolyten verbessert wird, wenn das mindestens teilweise mit einem Glykolether und/oder Alkylglykolether veretherte Harz außerdem anionisch modifiziert ist oder wenn dem mindestens teilweise mit einem Glykolether und/oder Alkylglykolether veretherten Harz ein anionisch modifiziertes Melamin-Formaldehyd-Harz beigemischt wird.

Als Glykolether werden im Rahmen der vorliegenden Erfindung oligomere und polymere Kondensationsprodukte von Glykolen, insbesondere von Ethylenglykol, verstanden. Als Glykolether kommen so z.B. Diglykol, Triglykol, Tetraglykol, Polyglykol, d.h. also Di-, Tri-, Tetra-oder Polyethylenglykol in Betracht. Als Alkylglykolether werden im Rahmen der vorliegenden Erfindung Monoalkylether, insbesondere Mono-$C_1$-$C_4$-alkylether, von Glykolen, z.B. von Ethylenglykol, und von den vorgenannten Glykolethern, also von oligomeren oder polymeren Kondensationsprodukten von Glykolen, insbesondere von Ethylenglykol, verstanden. Beispiele für geeignete Alkylglykolether sind: Methylglykol ( = Ethylenglykol-mono-methylether), Methyldiglykol ( = Diethylenglykol-mono-methylether), Butyl-triglykol ( = Triethylenglykol-mono-butylether). Als Alkylglykolether sind Alkylether der vorgenannten Glykolether, also z.B. Ethyl-diethylenglykol, Propyl-triethylenglykol und insbesondere Methyl-diethylenglykol bevorzugt.

Als anionische Modifizierungsmittel gelten Alkalisulfite und/oder Alkalisulfamate.

In der Regel wird ein mindestens teilweise mit einem Glykolether und/oder Alkylglykolether verethertes Melamin-Formaldehyd-Harz mit einem Melamin:Formaldehyd-Verhältnis von 1 : (2 bis 7) verwendet. Geeignete Melamin-Formaldehyd-Harze können durch Kondensation von Melamin und Formaldehyd im Molverhältnis 1 : (2 bis 7) unter Zusatz pro mol Melamin von 1 bis 5 mol, vorzugsweise 1 bis 3 mol, eines Glykolethers und/oder Alkylglykolethers, 0 bis 1 mol, vorzugsweise 0 bis 0,4 mol, eines ein-oder mehrwertigen Alkohols und/oder nicht reduzierenden Zuckers und/oder 0 bis 1 mol, vorzugsweise 0 bis 0,4 mol, Alkalisulfit und/oder Alkalisulfamat hergestellt werden.

Die Herstellung der mit Glykolether und/oder Alkylglykolether modifizierten Harze erfolgt nach einem der für veretherte Melamin-Formaldehyd-Harze bekannten Verfahren. Als besonders einfach und vorteilhaft hat sich die Umsetzung von Melamin mit weitgehend wasserfreiem Formaldehyd in Gegenwart des Glykolethers und/oder Alkylglykolethers sowie gegebenenfalls eines ein-oder mehrwertigen Alkohols und/oder nicht reduzierenden Zuckers und/oder Alkalisulfits bzw. -sulfamats bei Temperaturen zwischen 70°C und dem Siedepunkt des Reaktionsgemisches, vorzugsweise bei 80 bis 95°C, bei einem Anfangs-pH-Wert von 7 bis 11, vorzugsweise 7,5 bis 10, ganz besonders bevorzugt 8,5 bis 9,8, erwiesen, wobei die Kondensation höchstens bis zu einer begrenzten Eiswasserverdünnbarkeit bzw. höchstens so weit getrieben wird, bis eine mit Wasser verdünnte Probe bei Zimmertemperatur gerade trüb wird. Dabei kann es aufgrund der Nachkondensation während des Abkühlens geschehen, daß die Wasserverdünnbarkeit auch auf Werte unter 1 : 10 sinkt. Dabei darf die Verdünnbarkeit jedoch nicht so weit abfallen, daß bei der Verarbeitung Ausfällungen auftreten. Diese Grenze liegt in der Regel bei einer Wasserverdünnbarkeit von etwa 1 : 5.

Die Einstellung des pH-Wertes bei der Kondensation erfolgt vorzugsweise durch Zugabe eines tertiären Amins, z.B. eines Dialkylalkanolamins.

Als weitgehend wasserfreier Formaldehyd kann z.B. handelsüblicher Paraformaldehyd verwendet werden, der z.B. bis zu ca. 10 Gew.% Wasser enthalten kann.

Bei der Herstellung der Harze können auch Gemische von 2 oder mehr Glykolethern und/oder Alkylglykolethern verwendet werden. In vielen Fällen wird ein Gemisch aus einem Glykolether und einem Alkylglykolether verwendet.

Der gegebenenfalls zum Einsatz kommende zusätzliche ein-oder mehrwertige Alkohol und/oder nicht-reduzierende Zucker dient zur Verbesserung der Wasserlöslichkeit und der Haltbarkeit der Harze. Als derartige zusätzliche Alkohole sind z.B. geeignet: Methanol, Ethanol, Glykol, Glyzerin, Sorbit, andere ein-bzw. mehrwertige Alkohole einzeln oder in Mischungen untereinander. Als nicht-reduzierender Zucker wird normalerweise Saccharose (= Rübenzucker, Rohrzucker) verwendet. Es kann auch ein Gemisch aus mehreren nicht reduzierenden Zuckern eingesetzt werden.

Als Alkalisulfite oder Alkalisulfamate werden z.B. Kalium-oder Natrium-sulfite oder -sulfamate in Form von Einzelverbindungen oder in Form von Gemischen mehrerer Alkalisulfite und/oder Alkalisulfamate verwendet.

Anstelle der Verwendung eines mindestens teilweise mit einem Glykolether und/oder Alkylglykolether veretherten und gleichzeitig anionisch modifizierten Harzes ist es auch möglich, ein mindestens teilweise mit einem Glykolether und/oder Alkylglykolether verethertes, nicht anionisch modifiziertes Melamin-Formaldehyd-Harz im Gemisch mit einem anionisch modifizierten Melamin-Formaldehyd-Harz zu verwenden. Das anionisch modifizierte Melamin-Formaldehyd-Harz kann dem mindestens teilweise mit einem Glykolether und/oder Alkylglykolether veretherten Harz bis zu 60 Gew.%, bezogen auf Festharze, zugesetzt werden. Dieses anionisch modifizierte Melamin-Formaldehyd-Harz wird in an sich bekannter Weise, z.B. durch Kondensation von Melamin mit wäßrigem Formaldehyd im Molverhältnis 1 : (2 bis 7) unter Zusatz pro mol Melamin von 0 bis 1 mol eines oder mehrerer ein-oder mehrwertiger Alkohole und/oder nicht-reduzierenden Zucker und 0,1 bis 1 mol Alkalisulfit und/oder Alkalisulfamat hergestellt. Sowohl bei der Herstellung des anionisch modifizierten, mindestens teilweise mit einem Glykolether und/oder Alkylglykolether veretherten Melamin-Formaldehyd-Harzes als auch bei der Herstellung eines anionisch modifizierten, zur Abmischung mit einem mindestens teilweise mit einem Glykolether und/oder Alkylglykolether veretherten Melamin-Formaldehyd-Harz vorgesehenen Melamin-Formaldehyd-Harz können bis zu 50 Gew.%, vorzugsweise bis zu 30 Gew.%, durch Harnstoff ersetzt werden.

Die so hergestellten Harze, Harzmischungen oder Mischharze werden für den Gerbprozeß in üblicher Weise eingesetzt. Es werden z.B. in üblicher Weise geweichte, geäscherte und gebeizte Häute, gleich welcher Tiergattung, in wäßriger Flotte bei pH-Werten von 7 bis 8,5 mit 4 bis 20 %, bezogen auf Blößengewicht, der erfindungsgemäß eingesetzten Harzlösungen bei Temperaturen von 30 bis 45°C in einem der in Gerbereien üblichen Gerbgefäße ca. 6 bis 8 h behandelt. Danach wird die Temperatur der Flotte auf bis zu 50°C erhöht und dem Bad nach einer weiteren Laufzeit von 1 h 0,5 bis 3 %, bezogen auf Blößengewicht, eines sauren Katalysators, zugesetzt. Als saure Katalysatoren können Säuren, inbesondere die Haut nicht schädigende organische Säuren, wie z.B. Ameisensäure, oder sauer reagierende Salze, wie z.B. Ammoniumchlorid, allein oder im Gemisch miteinander verwendet werden. Danach werden die Leder abgelagert und wie jedes andere gegerbte Hautmaterial weiterbearbeitet.

Das Verfahren läßt sich auf allen Leder-, Fell- und Pelzfellarten mit Erfolg durchführen.

Die bei dem erfindungsgemäßen Verfahren erhaltenen Leder besitzen je nach Prozeßführung Schrumpfungstemperaturen von 70 bis 90°C, haben eine gute Fülle, sind weich bis standig, weisen aufgrund ihres überwiegend kationischen Charakters sehr gute Färbeeigenschaften für das Färben mit handelsüblichen anionischen Farbstoffen auf und stellen wegen ihrer auch im Querschnitt weißen Farbe eine hervorragende Basis für die Herstellung reinweißer Leder dar. Sie sind festnarbig, besitzen eine sehr gute Lichtechtheit und ein ähnliches Abriebsverhalten, Zugfestigkeit und Weiterreißverhalten wie chromgegerbtes Leder, sowie gute selbstverlöschende Eigenschaften nach der Berührung mit einer Zündflamme und geben die Freiheit jeglicher Art der in der Lederherstellung üblichen Nachbehandlung, wie Nachgerbung, Fettung oder Zurichtung.

Die besonderen Vorteile des erfindungsgemäßen Verfahrens liegen neben den sehr guten Ledereigenschaften und der Möglichkeit, chrom- bzw. mineralfreie Leder herzustellen, in der Umweltfreundlichkeit und Einfachheit des Prozesses. Das Verfahren erspart sowohl den abwasserbelastenden Pickel vor der Gerbung als auch den im Mineralgerbverfahren notwendigen Neutralisationsschritt. Die Gerberei abwässer werden durch keinerlei ökologisch bedenkliche Mineralsalze belastet.

Die folgenden Beispiele 1 bis 16 betreffen die Herstellung der Melamin-Formaldehyd-Harze. Die dabei angegebenen Feststoffgehalte wurden ermittelt, indem eine 2 g Probe des Harzes im Aluminiumschälchen 1 h bei 120°C gelagert und der Gewichtsverlust bestimmt wurde. Die Wasserverdünnbarkeit der fertigen Harzlösungen wurde, soweit nichts anderes angegeben ist, bei 23°C gemessen. Die Lagerung erfolgte bei Raumtemperatur. Die Grenze der Haltbarkeit der Harze ist dann erreicht, wenn die Harzlösung trüb und/oder geliert ist. Die pH-Bestimmung erfolgte nach Verdünnung mit Wasser auf max. 50 Vol.% Harzlösung. In den Beispielen steht MDEG für Methyldiethylenglykol ($= H_3COCH_2CH_2OCH_2CH_2OH$). Der verwendete Paraformaldehyd besaß in allen Beispielen einen Wassergehalt von 10 Gew.%. Die Beispiele 17 bis 33 betreffen die Durchführung des erfindungsgemäßen Verfahrens.

Beispiel 1:

In eine Lösung aus 500 g MDEG und 82 g Triethylenglykol werden bei pH 9,1 (eingestellt mit Dimethylaminoethanol) 345 g Melamin (M), 290 g Paraformaldehyd (F) mit einem Wassergehalt von 10 Gew.% (Molverhältnis M : F = 1 : 3,18) und 52 g Glyzerin eingetragen. Nach einer Kondensationszeit von ca. 30 min bei 90°C ist das Melamin vollständig gelöst, nach weiteren ca. 40 min tritt begrenzte Eiswasserverdünnbarkeit auf, d.h. einige Tropfen Harzlösung verursachen Trübung einer Eis-Wasser-Mischung.

Die Kondensation wird durch Abkühlung abgebrochen, und durch Zugabe von 100 ml Wasser wird ein Feststoffgehalt von 67 Gew.% eingestellt. Das unbegrenzt wasserverdünn bare Produkt besitzt einen pH-Wert von 8,2. Die gut fließfähige Harzlösung ist über 5 Monate haltbar, wobei nach ca. 6 Wochen leichte Opazität auftritt.

Beispiel 2:

600 g MDEG und 240 g 70gew.%ige wäßrige Sorbitlösung werden mit Dimethylaminoethanol auf pH 9,6 eingestellt. Dann werden 348 g Paraformaldehyd (10 Gew.% $H_2O$) und 414 g Melamin eingetragen (M : F = 1 : 3,18). Nach ca. 80 min Kondensation bei 90°C ist die Verdünnbarkeit mit Wasser bei Raumtemperatur begrenzt, und die Kondensation wird durch Abkühlen abgebrochen. Der Feststoffgehalt wird mit 120 ml Wasser auf 70 Gew.% eingestellt. Das Produkt mit einem pH-Wert von 9,3 ist im Verhältnis 1 : 8,5 mit Wasser verdünnbar und über 5 Monate haltbar.

Beispiel 3:

In eine Lösung aus 508 g MDEG, 27 g Triethylenglykol, 52,5 g Glyzerin und 70 ml Wasser werden bei pH 8,9 (eingestellt mit Dimethylaminoethanol) 350 g Melamin und 300 g Paraformaldehyd (10 Gew.% $H_2O$) eingetragen (M : F = 1 : 3,24). Nach 1 h Kondensation bei 90°C ist die Wasserverdünnbarkeit bei Raumtemperatur begrenzt. Die Harzlösung wird mit 70 ml Wasser auf einen Festkörpergehalt von 69 Gew.% eingestellt. Das Produkt (pH 10,0) besitzt eine Wasserverdünnbarkeit von 1 : 14 und ist über 5 Monate haltbar.

Beispiel 4:

145 g MDEG und 19 g n-Butyldiglykol werden mit Dimethylaminoethanol auf einen pH-Wert von 8,8 eingestellt und mit 100 g Melamin und 85 g Paraformaldehyd (10 Gew.% $H_2O$) versetzt (M : F = 3,21). Nach ca. 90 min Kondensation bei 90°C ist die Verdünnbarkeit mit Eiswasser begrenzt. Mit 30 ml Wasser wird auf einen Feststoffgehalt von 61 Gew.% eingestellt. Das Produkt (pH 8,7) besitzt eine unbegrenzte Wasserverdünnbarkeit. Die Haltbarkeit beträgt 2 Wochen, wobei nach 1 Woche leichte Opazität auftritt.

Beispiel 5:

Eine Suspension von 100 g Melamin und 68 g Paraformaldehyd (10 Gew.% $H_2O$; M : F = 1 : 2,57) in 145 g MDEG, 24 g Triethylenglykol und 15 g Glyzerin wird mit Dimethylaminoethanol auf pH 9,1 eingestellt und ca. 75 min bei 90°C bis zur begrenzten Eiswasserverdünnbarkeit kondensiert. Das mit 30 ml Wasser auf einen Feststoffgehalt von 64 Gew.% eingestellte Produkt (pH 8,4) ist unendlich wasserverdünnbar. Nach 5 h tritt leichte Opazität, nach ca. 2 Wochen leichte Trübung auf.

Beispiel 6:

100 g Melamin und 85 g Paraformaldehyd (10 Gew.% $H_2O$; M : F = 1 : 3,21) werden in 200 g MDEG, 24. g Triethylenglykol und 15 g Glyzerin suspendiert und mit Dimethylaminoethanol auf pH 9,1 eingestellt. Die Kondensation erfolgt zunächst ca. 40 min bei 90°C - zu diesem Zeitpunkt ist das Melamin vollständig gelöst - und anschließend ca. 50 min bei 85°C bis zur begrenzten Eiswasserverdünnbarkeit. Das Produkt, mit 30 ml Wasser auf einen Feststoffgehalt von 62 Gew.% eingestellt, ist unbegrenzt wasserverdünnbar und über 10 Wochen haltbar. Der pH-Wert beträgt 8,2.

Beispiel 7:

In eine Lösung aus 290 g MDEG, 24 g Triethylengykol und 15 g Glyzerin, die mit Dimethylaminoethanol auf pH 9.0 eingestellt worden war, wurden 100 g Melamin und 165 g Paraformaldehyd (10 Gew.% $H_2O$; M : F = 1 : 6,24) eingetragen. Nac einer Kondensationszeit von 5 h bei 90°C wurde mit 30 ml Wasser auf einen Feststoffgehalt von 57 Gew.% eingestellt. Das Produkt (pH 7,5) ist unbegrenzt mit Wasser verdünnbar und über 10 Wochen haltbar.

Beispiel 8:

215 g Ethyltriethylenglykol und 24 g Triethylenglykol werden mit Dimetylaminoethanol auf pH 8,9 eingestellt. Nach der Zugabe von 100 g Melamin, 85 g Paraformaldehyd (10 Gew.% $H_2O$; M : F = 1 : 3,21) und 15 g Glyzerin wird ca. 40 min bei 90°C bis zur begrenzten Eiswasserverdünnbarkeit kondensiert. Das Produkt wird mit 30 ml $H_2O$ auf einen Feststoffgehalt von 71 Gew.% eingestellt, ist unbegrenzt wasserverdünnbar und über 10 Wochen haltbar, wobei nach einigen Tagen leichte Opazität auftritt. Der pH-Wert beträgt 8,2.

Beispiel 9:

20 g Rübenzucker werden in 200 g MDEG und 10 g $H_2O$ gelöst und die Lösung mit Dimethylaminoethanol auf pH 8,9 eingestellt, danach werden 138 g Melamin und 116 g Paraformaldehyd (10 Gew.% $H_2O$; M : F - 1 : 3,18) eingetragen. Nach einer Kondensationszeit von 90 min bei 90°C ist begrenzte Verdünnbarkeit mit Eiswasser erreicht. Die Harzlösung wird mit 40 ml Wasser auf einen Feststoffgehalt von 73 Gew.% eingestellt. Das Produkt (pH 8,4) ist unbegrenzt wasserverdünnbar und ca. 3 Wochen haltbar, wobei nach 10 Tagen leichte Trübung auftritt.

Beispiel 10:

124 g MDEG, 24 g Triethylenglykol und 15 g Glyzerin werden mit Diemthylaminoethanol auf pH 9,1 eingestellt und mit 100 g Melamin und 85 g Paraformaldehyd (10 Gew.% $H_2O$; M : F = 1 : 3,21) versetzt. Nach einer Kondensationszeit von 70 min bei 90°C tritt begrenzte Eiswasserverdünnbarkeit ein. Die Harzlösung wird mit 30 ml $H_2O$ auf einen Feststoffgehalt von 72 Gew.% eingestellt und ist in dieser Form bei einem pH-Wert von 8,1 unbegrenzt mit Wasser verdünnbar und ca. 4 Wochen haltbar, wobei nach ca. 3 Wochen leichte Opazität auftritt.

Beispiel 11:

Eine Lösung aus 145 g MDEG, 24 g Triethylenglykol, 15 g Glyzerin und 4 g Methanol wird mit Dimethylaminoethanol auf pH 8,5 eingestellt und mit 100 g Melamin sowie 85 g Paraformaldehyd (10 Gew.% $H_2O$; M : F = 1 : 3,21) versetzt. Nach einer Kondensationszeit von ca. 40 min bei 90°C ist das Melamin vollständig gelöst, nach weiteren ca. 20 min Kondensation bei 85°C tritt begrenzte Eiswasserverdünnbarkeit auf. Die Harzlösung wird

mit 30 ml $H_2O$ auf einen Feststoffgehalt von 67 Gew.% eingestellt und ist in dieser Form (pH 8,5) unbegrenzt wasserverdünnbar und ca. 10 Wochen haltbar, wobei nach ca. 2 Wochen leichte Opazität auftritt.

Beispiel 12:

Eine Suspension von 100 g Melamin und 85 g Paraformaldehyd (10 Gew.% $H_2O$; M : F = 1 : 3,21) in 185 g Triethylenglykol wird mit Diemthylaminoethanol auf pH 9,0 eingestellt und bis 85°C bis zur begrenzten Verdünnbarkeit mit Eiswasser kondensiert (ca. 70 min). Die klare, hochviskose Harzlösung wird mit 30 ml $H_2O$ auf einen Feststoffgehalt von ca. 80 Gew.% eingestellt. Das Produkt mit einem pH-Wert von 8,1 ist im Verhältnis 1 : 9 mit Wasser verdünnbar und über 6 Wochen haltbar.

Beispiel 13:

Eine Lösung aus 250 g MDEG, 41 g Triethylenglykol und 26 g Glyzerin wird mit 172 g Melamin und 145 g Paraformaldehyd (10 Gew.% $H_2O$; M : F = 1 : 3,19) versetzt und mit Dimethylaminoethanol auf pH 9,3 eingestellt. Die Kondensation wird bei einer begrenzten Eiswasserverdünnbarkeit durch Abkühlen abgebrochen, danach werden 50 ml Wasser und 20 ml Methanol eingetragen. Die Harzlösung (pH-Wert 8,3) besitzt einen Feststoffgehalt von 63 Gew.%. Sie ist unbegrenzt wassverdünnbar und über 4 Wochen haltbar.

Beispiel 14:

1016 g Treithylenglykol werden mit Diemthylaminoethanol auf pH 9,6 eingestellt und mit 523 g Paraformaldehyd (10 Gew.% $H_2O$) und 550 g Melamin (M : F = 1 : 3,6) versetzt. Die Reaktionsmischung wird auf 80°C aufgeheizt, die Kondensation erfolgt ca. 3 h 45 min bis zur begrenzten Verdünnbarkeit mit Eiswasser. Während des Abkühlens wird mit 1,2 l $H_2O$ ein Festkörpergehalt von ca. 55 Gew.% eingestellt. Der pH-Wert der unbegrenzt waserverdünnbaren Harzlösung beträgt 8,7, die Haltbarkeit beträgt über 6 Wochen.

Beispiel 15:

Eine Mischung aus 210 g Triethylenglykol und 15 g Methanol wird mit Dimethylaminoethanol auf pH 9,5 (gemessen 1 : 1 mit $H_2O$ verdünnt) eingestellt. Unter Rühren werden bei 40°C nacheinander 156 g Paraformaldehyd (10 Gew.% $H_2O$), 36 g Rübenzucker, 66 g 40gew.%ige wäßrige Natriumsulfamatlösung, 10 g Harnstoff und 126 g Melamin (M : F = 1 : 4,73) eingetragen. Die Kondensation erfolgt bei 85°C, bis mit gesättigter wäßriger NaCl-Lösung eine Verdünnbarkeit (gemessen bei 20°C) von 1 : 3 erreicht ist (Dauer ca. 5 1/2 h). Beim Abkühlen wird mit 280 g $H_2O$ ein Feststoffgehalt von ca. 55 Gew.% eingestellt. Der pH-Wert der unbegrenzt wasserverdünnbaren Harzlösung liegt bei 8,35, die Haltbarkeit beträgt bisher 2 Monate.

Beispiel 16:

In einem Glaskolben werden 923 g wäßriger Formaldehyd 39 %, 2 g Kaliumcarbonat, 165 g Rübenzucker, 170 ml deionisiertes Wasser, 297 g Na-sulfamatlösung 40 %, 252 g Melamin und 87 g Harnstoff in der angegebenen Reihenfolge eingetragen, auf 85°C aufgeheizt und bei dieser Temperatur kondensiert, bis die Verdünnbarkeit mit gesättigter NaCl-Lösung, bei 20°C gemessen, bei 1 : 2,5 liegt. Nun wird auf Raumtemperatur abgekühlt.

Beispiel 17:

Rindshaut wird, wie in der Praxis der Lederherstellung üblich, geweicht, geäschert, entfleischt, entkälkt und gebeizt. Der pH-Wert der Blöße beträgt nach dem Beizen 7,8.

Die Prozentangaben der weiteren Prozeßschritte beziehen sich auf das Entfleischgewicht der Rindshaut. Die Blöße wird in einem üblichen Gerbgefäß in 50 % Wasser von 38°C aufgenommen und mit 10 Gew.% Harzlösung gemäß Beispiel 1 versetzt und 6 h laufen gelassen. Dann werden weitere 50 % Wasser von 55°C zugesetzt, und es wird für eirie weitere Stunde bei dieser Temperatur laufen gelassen. Anschließend wird 1 % Ameisensäure (85%ig) und 1 % $NH_4Cl$ zugesetzt. Nach einer Laufzeit von weiteren 30 min werden die Leder aus dem Gerbgefäß genommen, über Nacht abgelagert und nach den in der Lederherstellung üblichen weiteren Prozeßschritten, wie Falzen, Fetten, Nachgerben, Färben usw. fertiggestellt.

Die so erhaltenen Leder weisen einen feinen gleichmäßigen und festen Narben auf, sind gut gefüllt, besitzen einen glatten angenehmen Griff, sehr gute Farbegalität und Lichtechtheit sowie eine gute Zugfestigkeit, wie aus den in der Tabelle angegebenen Werten hervorgeht. Die Leder weisen außerdem gute selbstverlöschende Eigenschaften nach Berührung mit einer Zündflamme auf.

Beispiel 18:

Rindshaut wird, wie in Beispiel 17 beschrieben, vorbehandelt. Als Gerbmittel dient eine 4gew.%ige wäßrige Lösung des Harzes gemäß Beispiel 1, bezogen auf Blößengewicht. Die weiteren Arbeitsbedingungen entsprechen den in Beispiel 17 beschriebenen.

Das so erhaltene Leder besitzt eine höhere Zugfestigkeit als das gemäß Beispiel 17 hergestellte, jedoch eine geringere Fülle.

Wird die Rindshaut in einer 20gew.%igen wäßrigen Lösung (bezogen auf Blößengewicht) behandelt, so erhält man Leder mit einer besseren Fülle, jedoch mit niedrigerer Zugfestigkeit als das gemäß Beispiel 17 hergestellte.

Beispiele 19 bis 32:

Rindshaut wird mit einer jeweils 10gew.%igen wäßrigen Lösung (bezogen auf Blößengewicht) der gemäß Beispiele 2 bis 15 hergestellten Harze unter den Arbeitsbedingungen gemäß Beispiel 17 behandelt. Die Eigenschaften der so hergestellten Leder entsprechen den gemäß Beispiel 17 hergestellten. Die Werte für die Schrumpftemperatur, Zugfestigkeit, Weiterreißfestigkeit und Bruchdehnung sind in der am Schluß angegebenen Tabelle zusammengestellt.

Beispiel 33:

Rindshaut wird, wie in Beispiel 17 beschrieben, behandelt. Als Gerbmittel dient eine Mischung aus 5 % Harzlösung gemäß Beispiel 14 und 5 % Harzlösung gemäß Beispiel 16 (Mengenangaben bezogen auf Blößengewicht) in Wasser. Die so erhaltenen Leder sind voll im Griff sehr elastisch. Der Narben ist fein und eng anliegend, und das Leder hat eine gute Schleifbarkeit.

0 264 628

T A B E L L E

| Beispiel Nr. | Harz gemäß Beispiel Nr. | Schrumpf Temp.($^\circ$C) | Zugfestig- keit (kg/cm$^2$) | Weiterreiß festigkeit (kg/cm$^2$) | Bruchdeh- nung (%) |
|---|---|---|---|---|---|
| 17 | 1 | 87 | 286 | 42 | 58 |
| 19 | 2 | 82 | 210 | 31 | 48 |
| 20 | 3 | 82 | 227 | 29 | 52 |
| 21 | 4 | 80 | 193 | 25 | 48 |
| 22 | 5 | 83 | 155 | 27 | 42 |
| 23 | 6 | 82 | 153 | 31 | 41 |
| 24 | 7 | 85 | 272 | 36 | 68 |
| 25 | 8 | 81 | 144 | 22 | 32 |
| 26 | 9 | 84 | 157 | 24 | 44 |
| 27 | 10 | 80 | 167 | 47 | 52 |
| 28 | 11 | 84 | 157 | 34 | 50 |
| 29 | 12 | 82 | 252 | 26 | 83 |
| 30 | 13 | 85 | 260 | 31 | 88 |
| 31 | 14 | 77 | 447 | 81 | 100 |
| 32 | 15 | 83 | 256 | 44 | 100 |
| 33 | 14 + 16 | 84 | 182 | 37 | 80 |

## Ansprüche

1. Verfahren zur Gerbung von Leder, wobei die Häute mit einem wasserlöslichen Melamin-Formaldehyd-Harz, zum Schluß unter Zusatz eines sauren Katalysators, gegerbt werden, dadurch gekennzeichnet, daß ein Melamin-Formaldehyd-Harz verwendet wird, das zumindest teilweise mit einem Glykolether und/oder Alkylglykolether verethert ist.

2. Verfahren nach Anspruch 1, dadurch gekennzeichnet, daß ein Melamin-Formaldehyd-Harz mit einem Molverhältnis Melamin : Formaldehyd = 1 : (2 bis 7) verwendet wird.

3. Verfahren nach Anspruch 1, dadurch gekennzeichnet, daß ein Melamin-Formaldehyd-Harz verwendet wird, das durch Kondensation von Melamin und Formaldehyd im Molverhältnis 1 : (2 bis 7) unter Zusatz pro mol Melamin von 1 bis 5 mol eines Glykolethers und/oder alkylglykolethers, 0 bis 1 mol eines ein-oder mehrwetigen Alkohols und/oder nicht-reduzierenden Zuckers, und/oder 0 bis 1 mol Alkalisulfit und/oder Alkalisulfamat hergestellt worden ist.

4. Verfahren nach Anspruch 1, dadurch gekennzeichnet, daß ein Melamin-Formaldehyd-Harz verwendet wird, das durch Kondensation von Melamin und Formaldehyd im Molverhältnis 1 : (2 bis 7) unter Zusatz von 1 bis 3 mol eines Glykolethers und/oder Alkylglykolethers, 0 bis 0,4 mol eines ein-oder mehrwertigen Alkohols und/oder nicht-reduzierenden Zuckers und/oder 0 bis 0,4 mol Alkalisulfit und/oder Alkalisulfamat hergestellt worden ist.

5. Verfahren nach einem oder mehreren der Ansprüche 1 bis 4, dadurch gekennzeichnet, daß ein zumidnest teilweise mit einem Glykolether und/oder Alkylglykolether verether tes Melamin-Formaldehyd-Herz verwendet wird, dem bis zu 60 Gew.% eines anionisch modifizierten Melamin-Formaldehyd-Harzes zugesetzt worden sind.

Verfahren nach Anspruch 5, dadurch gekennzeichnet, daß ein anionisch modifiziertes Melamin-Formaldehyd-Harz zugesetzt worden ist, bei dessen Herstellung bis zu 50 Gew.% des Melamins durch Harnstoff ersetzt worden sind.

7. Verfahren nach Anspruch 5 und/oder 6, dadurch gekennzeichnet, daß ein anionisch modifiziertes Melamin-Formaldehyd-Harz zugesetzt worden ist, bei dessen Herstellung bis zu 30 Gew.% des Melamins durch Harnstoff ersetzt worden sind.

8. Verfahren nach einem oder mehreren der Ansprüche 1 bis 7, dadurch gekennzeichnet, daß ein zumindest teilweise mit einem Glykolether und/oder Akylglykolether verethertes und anionisch modifiziertes Melamin-Formaldehyd-Harz verwendet wird, bei dessen Herstellung bis zu 50 Gew.% des Melamins durch Harnstoff ersetzt worden sind.

9. Verfahren nach einem oder mehreren der Ansprüche 1 bis 8, dadurch gekennzeichnet, daß ein zumindest teilweise mit einem Glykolether und/oder Alkylglykolether verethertes und anionisch modifiziertes Melamin-Formaldehyd-Harz verwendet wird, bei dessen Herstellung bis zu 30 Gew.% des Melamins durch Harnstoff ersetzt worden sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-2 944 046 (L. SELLET) <br> * Spalte 1, Zeilen 32-39; Ansprüche 1,2,7 * <br> --- | 1 | C 14 C 3/18 <br> C 14 C 3/20 |
| A | US-A-3 068 190 (G.F. ALELIO) <br> * Spalte 6, Zeilen 51-70 * <br> --- | 1 | |
| A | DE-C- 827 225 (AMERICAN CYANAMID CO.) <br> * Ansprüche 1,8 * <br> --- | 1 | |
| A | DE-B-1 264 678 (DIAMOND ALKALI CO.) <br> * Anspruch * <br> ----- | 1 | |
| | | | RECHERCHIERTE SACHGEBIETE (Int. Cl.4) <br><br> C 14 C |

Der vorliegende Recherchenbericht wurde für alle Patentansprüche erstellt

| Recherchenort | Abschlußdatum der Recherche | Prüfer |
|---|---|---|
| DEN HAAG | 05-01-1988 | VON KUZENKO M.T. |